# EUROPEAN PATENT SPECIFICATION

(11) **EP 0 682 408 B1**
(45) Date of publication and mention of the grant of the patent: **21.06.2000**
(21) Application number: 95106866.7
(22) Date of filing: 05.05.1995
(51) Int. Cl.: H03H 9/05

(54) **SAW device**
Oberflächenwellenanordnung
Dispositif à ondes acoustiques de surface

(30) Priority: 09.05.1994 JP 9498294
(43) Date of publication of application: 15.11.1995
(73) Proprietor: MURATA MANUFACTURING CO., LTD., Nagaokakyo-shi Kyoto-fu 226 (JP)
(72) Inventor: Morishita, Hideya, c/o Murata Man. Co., Ltd., Nagaokakyo-shi, Kyoto-fu (JP); Nakashima, Koji, c/o Murata Man. Co., Ltd., Nagaokakyo-shi, Kyoto-fu (JP)
(74) Representative: Schoppe, Fritz, Dipl.-Ing.

(56) References cited:
- US-A- 4 993 000
- PATENT ABSTRACTS OF JAPAN vol. 007 no. 251 (E-209) ,8 November 1983 & JP-A-58 138115 (MURATA SEISAKUSHO:KK) 16 August 1983,

## Description

The present invention relates to a SAW (surface acoustic wave) device having a SAW element which is fixed in a package consisting of a base substrate and a cap, and more particularly, it relates to a SAW device which is improved in frequency-temperature characteristics.

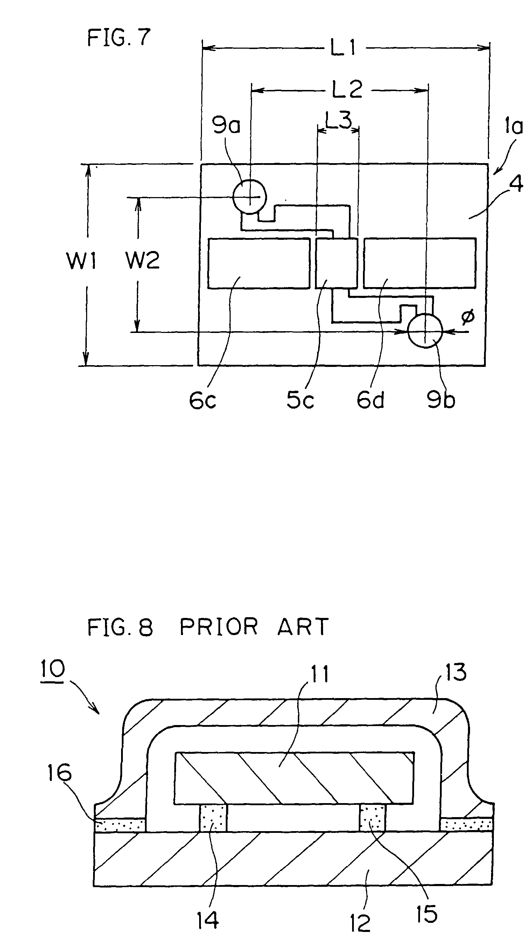

Fig. 8 is a sectional view typically showing an example of a conventional SAW device 10. This SAW device 10 has a SAW element 11, which is stored in a package consisting of a base substrate 12 and a cap 13.

The SAW element 11 comprises a piezoelectric substrate and at least one interdigital transducer (hereinafter referred to as IDT) which is formed on the piezoelectric substrate. The SAW element 11 is bonded onto the base substrate 12 through solder bumps 14 and 15, while downwardly directing the surface which is provided with the IDT. This method of fixing the SAW element 11 is called face down bonding.

The base substrate 12 is made of insulating ceramics such as alumina, for example. The cap 13 is fixed onto the base substrate 12, to enclose the SAW element 11. The cap 13 is made of a metal to have an opening in its lower portion, and bonded to the base substrate 1 by solder 16.

In the SAW device 10, frequency-temperature characteristics are preferably as flat as possible. Therefore, the thermal expansion coefficient of the SAW element 11 is ideally equal to that of the package consisting of the base substrate 12 and the cap 13. In practice, however, the thermal expansion coefficients cannot be equalized with each other due to the difference between the materials forming the SAW element 11 and the package. Under the present circumstances, therefore, the SAW element 11, the base substrate 12 and the cap 13 are prepared from materials having thermal expansion coefficients which are as close as possible to each other. In a reliability test such as a heat cycle test, however, the conventional SAW device 10 tends to cause problems such as remarkable fluctuation of its central frequency and breaking in the portions connected by the solder bumps 14 and 15 in practice.

US-A-4,993,000 discloses a surface acoustic wave filter having two transducers exciting surface acoustic waves and a propagating portion both disposed in a recess portion formed in a surface portion of a piezoelectric substrate. In- and output electrode pads are disposed outside of the recess portion. The pads are connected by taking-out electrodes traversing the step which is the boundary between the recess portion and the protruding portion.

It is the object underlying the present invention to provide a SAW device comprising a SAW element stored in a package, which can reduce fluctuation of a frequency characteristic following temperature change and suppress a breaking defect or the like.

This object is achieved by a SAW device according to claim 1.

According to a wide aspect of the present invention, provided is a SAW device comprising a SAW element, a base substrate which has the SAW element on board, and a cap which is bonded to the base substrate for enclosing the SAW element. The SAW element has a piezoelectric substrate, at least one IDT which is formed on the piezoelectric substrate for exciting surface waves, and a plurality of input/output electrodes which are electrically connected to the IDT. The plurality of input/output electrodes at least include first and second input/output electrodes which are arranged on both sides of the IDT along a waveguide path, so that a relation L2 < 3.5 x L3 is satisfied assuming that L2 represents the center distance between the first and second input/output electrodes and L3 represents the distance between both outer ends of the aforementioned at least one IDT along the waveguide path.

According to the present invention, the electrode pattern of the SAW element is noted with no direct attention to the difference between the thermal expansion coefficients of the material forming the SAW element and the package, for attaining the aforementioned object by bringing the electrode pattern into the aforementioned specific structure.

According to the present invention, the ratio of the center distance L2 between the input/output electrodes along the waveguide path to the distance L3 between both outer ends of the IDT along the waveguide path is rendered less than 3.5 as described above, whereby a breaking defect can be suppressed for reducing the amount of frequency fluctuation following temperature change. Further, the temperature coefficient can be so reduced that the maximum value temperature of a frequency deviation curve in heating and cooling measurement can be approached to a central temperature of 30°C, for example, while the hysteresis can be improved. It has been experimentally confirmed by the inventors that these effects can be attained by bringing the electrode pattern of the SAW element into the aforementioned structure. However, it has been completely unknown in general that the ratio of the distance L2 to the distance L3 influences on the frequency-temperature characteristics and the breaking defect.

According to a specific aspect of the present invention, the aforementioned at least one IDT includes first and second IDTs, and the distance L3 is defined by that between outer ends of the first and second IDTs along the waveguide path in this case. In the structure provided with the first and second IDTs, further, a pair of first input/output electrodes, i.e., hot-side and earth-side first input/output electrodes are electrically connected to the first IDT. Similarly, a pair of second input/output electrodes, i.e., hot-side and earth-side second input/output electrodes are electrically connected to the second IDT.

In the structure having the first and second IDTs as described above, a two-port SAW resonator, for example, can be structured.

However, the present invention is not restricted to a one-port SAW resonator described later with reference to an embodiment of the present invention and the two-port SAW resonator, but is also applicable to a transversal SAW filter having a plurality of IDTs, a SAW delay line, and the like.

According to another specific aspect of the present invention, the aforementioned SAW element is fixed to the base substrate by a conductive bonding material through face down bonding. In this case, the conductive bonding material is preferably prepared from a solder bump, which can readily carry out the bonding operation.

According to the present invention, the aforementioned cap is preferably made of a conductive material, so that the SAW element stored therein can be electromagnetically shielded and the cap can be bonded to the base substrate by the conductive bonding material.

Further, the SAW element which is employed for the inventive SAW device may comprise reflectors on both sides of a region provided with the IDT along the waveguide path, in addition to the IDT which is formed on the piezoelectric substrate. In this case, the reflectors can be formed by well-known proper reflectors such as grating reflectors.

The foregoing and other objects, features, aspects and advantages of the present invention will become more apparent from the following detailed description of the present invention when taken in conjunction with the accompanying drawings.
Fig. 1 is a sectional view typically showing the structure of a SAW device according to a first embodiment of the present invention;
Fig. 2 is a plan view showing a two-port SAW resonator which is employed for the SAW device according to the first embodiment of the present invention;
Fig. 3 is a typical plan view for illustrating an IDT;
Fig. 4 illustrates relations between distances L2 between input/output electrodes, center frequency shift amounts and breaking defect ratios in samples of the SAW device according to the first embodiment of the present invention;
Fig. 5 illustrates hysteresis characteristics of frequency deviation curves in heating and cooling steps in the SAW device according to the first embodiment of the present invention;
Fig. 6 illustrates hysteresis characteristics of frequency deviation curves in heating and cooling steps in a conventional SAW device;
Fig. 7 is a typical plan view for illustrating a one-port SAW resonator which is employed for a SAW device according to a second embodiment of the present invention; and
Fig. 8 is a typical sectional view for illustrating a conventional SAW device.

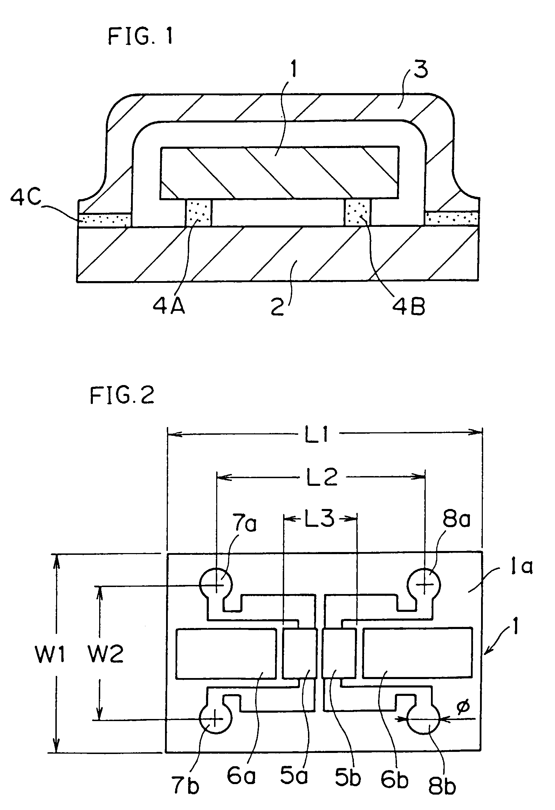

Fig. 1 is a typical plan view for illustrating a SAW device according to a first embodiment of the present invention.

In the SAW device according to this embodiment, a two-port SAW resonator serving as a SAW element 1 is stored in a package. This package has a base substrate 2 and a cap 3 which is bonded onto the base substrate 2.

The base substrate 2 is made of insulating ceramics such as alumina, for example, or a proper insulating material. Further, the base substrate 2 is provided thereon with electrodes (not particularly shown in Fig. 1) which are electrically connected with input/output electrodes of the SAW element 1. The electrodes provided on the base substrate 2 are employed for electrical connection.

The SAW element 1 is fixed onto the base substrate 2 by face down bonding. Namely, the SAW element 1 is bonded to the electrodes provided on the base substrate 2 by solder bumps 4A and 4B, while downwardly directing a surface provided with various electrodes described later.

The cap 3 is made of a metal according to this embodiment, and has an opening in its lower portion. Further, a portion of the cap 3 around the lower opening extends in parallel with the upper surface of the base substrate 2, so that this cap 3 is bonded to the base substrate 2 in this peripheral portion by a conductive bonding material 4C such as solder. The cap 3 seals the SAW element 1 to improve the sealing performance of the SAW device according to this embodiment, while serving an electromagnetic shielding function.

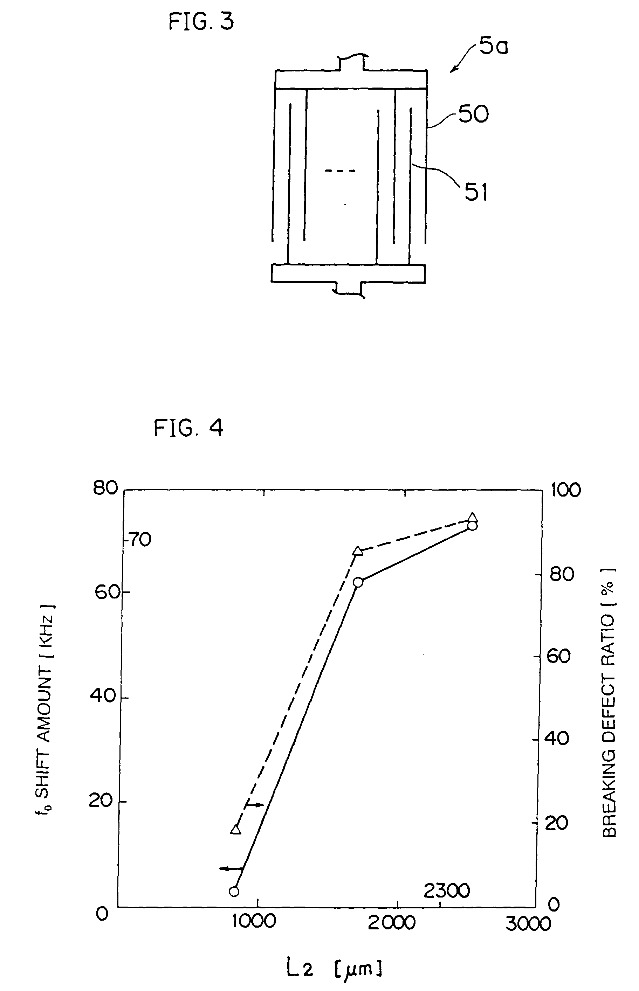

As shown in Fig. 2 in a plan view, the SAW element 1 is formed by a rectangular piezoelectric substrate 1a. First and second IDTs 5a and 5b are formed on an upper surface of the piezoelectric substrate 1a. As shown in Fig. 3 in an enlarged manner, the first IDT 5a has a comb electrode having a plurality of electrode fingers 50, and another comb electrode also having a plurality of electrode fingers 51. The electrode fingers 50 and 51 are arranged to interdigitate with each other as shown in Fig. 3.

The second IDT 5b is also formed by a pair of comb electrodes, similarly to the first IDT 5a.

Reflectors 6a and 6b are provided outside the region provided with the IDTs 5a and 5b. These reflectors 6a and 6b are arranged on outer sides of the IDTs 5a and 5b along a propagation direction of surface waves which are excited by the IDTs 5a and 5b, i.e., along a waveguide path. The reflectors 6a and 6b, which are formed by proper reflectors such as grating reflectors, are made of the same electrode material as the IDTs 5a and 5b.

A pair of first input/output electrodes 7a and 7b are electrically connected to the first IDT 5a. These input/output electrodes 7a and 7b are arranged on side portions of the waveguide path on the piezoelectric substrate la, to be electrically connected to hot-side and earth-side comb electrodes of the IDT 5a respectively. The input/output electrodes 7a and 7b are formed to have substantially circular shapes, as shown in Fig. 2.

Similarly to the above, second input/output electrodes 8a and 8b are electrically connected to the second IDT 5b. These input/output electrodes 8a and 8b are electrically connected to hot-side and earth-side comb electrodes of the IDT 5b respectively.

As hereinabove described, the first input/output electrodes 7a and 7b and the second input/output electrodes 8a and 8b are arranged on opposite sides of the region provided with the first and second IDTs 5a and 5b along'the waveguide path.

According to this embodiment, the first and second input/output electrodes 7a, 7b, 8a and 8b are provided on side portions of the reflectors 6a and 6b on outer sides of the region provided with the IDTs 5a and 5b along the waveguide path.

The SAW element 1 which is employed for the SAW device according to this embodiment is a two-port SAW resonator having two IDTs 5a and 5b, as hereinabove described.

Dimensions of the piezoelectric substrate 1a forming the SAW element 1 and the elements provided on the piezoelectric substrate 1a are represented by the following symbols:
L1 ... This symbol represents the length of the piezoelectric substrate 1a, i.e., the dimension along the waveguide path.
L2 ... This symbol represents the center distance between the first and second input/output electrodes 7a, 7b, 8a and 8b along the waveguide path. Namely, symbol L2 represents the center distance between the input/output electrodes 7a and 8a, that between the input/output electrodes 7b and 8b, that between the input/output electrodes 7a and 8b along the waveguide path, and that between the input/output electrodes 7b and 8a along the waveguide path.
L3 ... This symbol represents the distance between outer ends of the IDTs 5a and 5b along the waveguide path.
W1 ... This symbol represents the cross-directional dimension of the piezoelectric substrate 1a, i.e., the dimension along the direction perpendicular to that of the waveguide path.
W2 ... This symbol represents the center distance between the input/output electrodes 7a and 7b and that between the input/output electrodes 8a and 8b.
φ ... This symbol represents the diameter of the input/output electrodes 7a, 7b, 8a and 8b.

SAW oscillators having center frequencies of 433 MHz were prepared with dimensions L1 of 3840 µm, L3 of 656 µm, W1 of 2380 µm, W2 of 1580 µm and φ of 300 µm. Three types of samples were prepared by setting the dimensions L2 at 840 µm, 1670 µm and 2500 µm for Experimental Examples 1, 2 and 3 respectively.

The three types of two-port SAW oscillators obtained in the aforementioned manner were subjected to measurement of center frequencies and evaluation of breaking defect ratios. Fig. 4 shows relations between the dimensions L2, shift amounts of center frequencies f₀ and the breaking defect ratios. Referring to Fig. 4, the solid line shows the shift amounts of the central frequencies f₀, and the broken line shows the breaking defect ratios. It is understood that the shift amounts of the center frequencies f₀ and the breaking defect ratios are substantially proportionally increased as the dimensions L2 are increased.

In a reliability test of a SAW device, the shift amount of the center frequency f₀ must be not more than 70 kHz in case of 433 MHz, i.e., not more than 0.0162 % of the center frequency f₀. Thus, it is understood from Fig. 4 that the dimension L2 may be set to be not more than about 2300 µm, in order to reduce the shift amount of the center frequency f₀ to not more than 70 kHz.

In other words, it is understood that the shift amount of the center frequency f₀ is 70 kHz when the ratio L2/L3 of the dimension L2 to the dimension L3 is 2300/656, i.e., about 3.5. Thus, it is understood from the above result that the shift amount of the center frequency f₀ can be suppressed by reducing the ratio L2/L3 to not more than 3.5.

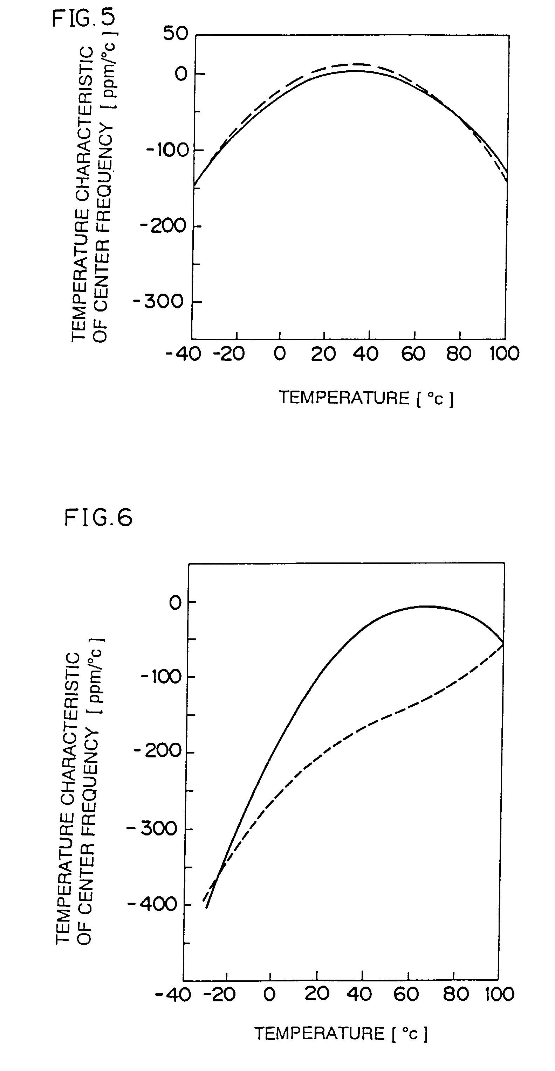

Samples of the first embodiment of the present invention and the prior art are now described with reference to Table 1 and Figs. 5 and 6.

**Table 1**

| Item | Prior Art | Embodiment |
|---|---|---|
| L1 [µm] | 3840 | 3840 |
| L2 [µm] | 2500 | 840 |
| L3 [µm] | 656 | 656 |
| W1 [µm] | 2380 | 2380 |
| W2 [µm] | 1580 | 1580 |
| φ [µm] | 400 | 300 |
| Cap | Iron | Iron |
| Carrier | Alumina | Alumina |
| Piezoelectric Substrate | Crystal | Crystal |

The samples of the SAW devices according to this embodiment and the prior art were prepared under the conditions shown in Table 1. As to the samples of this embodiment and the prior art obtained in the aforementioned manner, the shift amounts of center frequencies f₀ in a reliability test, temperature coefficients of center frequency-temperature characteristics, and maximum value temperatures of center frequency-temperature characteristic curves were measured. Table 2 shows the results.

**Table 2**

| Item of Measurement | Prior Art | Embodiment |
|---|---|---|
| ① f₀ Shift Amount [kHz] in Reliability Test | 72.7 | 3.0 |
| ② Temperature Coefficient of Center Frequency-Temperature Characteristics [ppm/°C] | 7.5 | 3.35 |
| ③ Maximum Value Temperature of Center Frequency-Temperature Characteristic Curve [°C] | 66.3 | 33.9 |

It is clearly understood from Table 2 that (1) the shift amount of the center frequency f₀ in the reliability test was remarkably reduced, (2) the temperature coefficient of the center frequency-temperature characteristics was also remarkably reduced, and (3) the maximum value temperature of the center frequency-temperature characteristic curve was reduced in the sample of the SAW device according to the first embodiment as compared with that of the prior art.

Further, hysteresis characteristics of frequency deviation curves in heating and cooling measurement were examined as to the samples of the SAW devices of the first embodiment and the prior art. The center frequency f₀ was measured in a step of heating each SAW device from -40°C to 100°C and then cooling the same to -40°C. Figs. 5 and 6 show the hysteresis characteristics of the samples according to the first embodiment and the prior art respectively. Referring to Figs. 5 and 6, solid lines show the temperature characteristics in the heating process, and broken lines show those in the cooling process. It is clearly understood from Figs. 5 and 6 that the SAW device according to the first embodiment exhibited an extremely small hysteresis as compared with that of the prior art.

While the SAW element 1 is formed by the two-port SAW resonator shown in Fig. 2 in the aforementioned first embodiment, the SAW element according to the present invention may have another structure. Fig. 7 is a typical plan view showing a one-port SAW resonator serving as a SAW element which is employed for a second embodiment of the present invention. In this SAW element, a single IDT 5c is formed on a piezoelectric substrate la. Therefore, the dimension L3 is defined by the distance between both ends of the IDT 5c along the waveguide path.

Further, reflectors 6c and 6d are formed on both sides of the IDT 5c along the waveguide path. These reflectors 6c and 6d can be formed similarly to the reflectors 6a and 6b in the first embodiment. The IDT 5c is formed by a pair of comb electrodes, so that hot-side and earth-side comb electrodes are connected to first and second input/output electrodes 9a and 9b respectively. The input/output electrodes 9a and 9b have substantially circular shapes. Further, the first and second input/output electrodes 9a and 9b are opposed to each other through the IDT 5c along the waveguide path. These input/output electrodes 9a and 9b are formed on side portions of the reflectors 6c and 6d respectively. In this case, the dimension L2 is defined by the length between the centers of the input/output electrodes 9a and 9b along the waveguide path.

As shown in Fig. 7, the remaining dimensions can be defined similarly to those shown in Fig. 2. Also in the one-port SAW resonator shown in Fig. 7, the shift amount of the center frequency fₒ in a reliability test as well as the temperature coefficient and the maximum value temperature of the center frequency-temperature characteristics can be reduced by setting the ratio L2/L3 at a value of less than 3.5.

## Claims

1. A SAW device comprising:
a piezoelectric substrate (1a);
one or more interdigital transducer (5a,5b;5c) being formed on said piezoelectric substrate (1a);
a plurality of input/output electrode terminals (7a, 7b,8a,8b;9a,9b) being electrically connected to said interdigital transducer (5a,5b;5c), said plurality of input/output electrode terminals at least including first (7a,7b;9a) and second (8a,8b;9b) input/output electrode terminals being arranged on both sides of said interdigital transducer at sides of the wave path;
characterized by
a base substrate (2) having said SAW element (1) on board; and
a (3) cap being bonded to said base substrate (2) for enclosing said SAW element (1);
wherein a relation L2 < 3.5 X L3 being satisfied assuming that L2 represents the center distance between said first and second input/output electrode terminals and L3 represents the distance between the outer ends of the area occupied by said one or more interdigital transducer (5a,5b;5c) along said wave path.

2. The SAW device in accordance with claim 1, wherein said one or more interdigital transducer includes first and second interdigital transducers (5a,5b).

3. The SAW device in accordance with claim 2, wherein a pair of first input/output electrode terminals (7a,7b) and a pair of second input/output electrode terminals (8a,8b) are electrically connected to said first and second interdigital transducers (5a,5b), respectively.

4. The SAW device in accordance with any of claims 1 to 3, wherein said SAW element (1) is fixed onto said base substrate (2) by a conductive bonding material (4a,4b) through face down bonding.

5. The SAW device in accordance with claim 4, wherein said conductive bonding material (4a,4b) is a solder bump.

6. The SAW device in accordance with claim 1, wherein said cap (3) is fixed to said base substrate (2) by a conductive bonding material (4c).

7. The SAW device in accordance with any of claims 1 to 4, wherein said one or more interdigital transducer (5a,5b;5c) is fixed to said base substrate (2) by a conductive bonding material.

8. The SAW device in accordance with any of claims 1 to 6, further comprising a pair of reflectors (6a,6b;6c,6d) being provided on both sides of said one or more interdigital transducer (5a,5b;5c) along said wave path.

## Patentansprüche

1. Ein SAW-Bauelement mit:
einem piezoelektrischen Substrat (1a);
einem oder mehreren Interdigitalwandlern (5a, 5b; 5c), die auf dem piezoelektrischen Substrat (1a) gebildet sind;
einer Mehrzahl von Eingangs/Ausgangselektrodenanschlüssen (7a, 7b, 8a, 8b; 9a, 9b), die mit dem Interdigitalwandler (5a, 5b; 5c) elektrisch verbunden sind, wobei die Mehrzahl von Eingangs/Ausgangselektrodenanschlüssen zumindest einen ersten (7a, 7b; 9a) und einen zweiten (8a, 8b; 9b) Eingangs/Ausgangselektrodenanschluß aufweist, die an beiden Seiten des Interdigitalwandlers seitlich zu dem Wellenleitungsweg angeordnet sind;
gekennzeichnet durch
ein Basissubstrat (2), auf dem das SAW-Element (1) angeordnet ist; und
eine Abdeckung (3), die mit dem Basissubstrat (2) verbunden ist, zum Umschließen des SAW-Elements (1);
wobei eine Beziehung L2 < 3,5 x L3 unter der Annahme erfüllt wird, daß L2 den Mittenabstand zwischen dem ersten und zweiten Eingangs/Ausgangselektrodenanschluß darstellt, und L3 den Abstand zwischen den äußeren Enden des Bereichs darstellt, der von dem einen oder den mehreren Interdigitalwandlern (5a, 5b; 5c) entlang des Wellenleitungswegs belegt wird.

2. Das SAW-Bauelement gemäß Anspruch 1, bei dem der eine oder die mehreren Interdigitalwandler einen ersten und einen zweiten Interdigitalwandler (5a, 5b) aufweisen.

3. Das SAW-Bauelement gemäß Anspruch 2, bei dem ein Paar von ersten Eingangs/Ausgangselektrodenanschlüssen (7a, 7b) und ein Paar von zweiten Eingangs/Ausgangselektrodenanschlüssen (8a, 8b) elektrisch mit dem ersten bzw. dem zweiten Interdigitalwandler (5a, 5b) verbunden sind.

4. Das SAW-Bauelement gemäß einem der Ansprüche 1 bis 3, bei dem das SAW-Element (1) durch ein leitfähiges Verbindungsmaterial (4a, 4b) mittels einer Face-Down-Verbindung an dem Basissubstrat (2) befestigt ist.

5. Das SAW-Bauelement gemäß Anspruch 4, bei dem das leitfähige Verbindungsmaterial (4a, 4b) ein Lötmittelhöcker ist.

6. Das SAW-Bauelement gemäß Anspruch 1, bei dem die Abdeckung (3) durch ein leitfähiges Verbindungsmaterial (4c) an dem Basissubstrat (2) befestigt ist.

7. Das SAW-Bauelement gemäß einem der Ansprüche 1 bis 4, bei dem der eine oder die mehreren Interdigitalwandler (5a, 5b; 5c) durch ein leitfähiges Verbindungsmaterial an dem Basissubstrat (2) befestigt ist/sind.

8. Das SAW-Bauelement gemäß einem der Ansprüche 1 bis 6, das ferner ein Paar von Reflektoren (6a, 6b; 6c, 6d), das auf beiden Seiten des einen oder der mehreren Interdigitalwandler (5a, 5b; 5c) entlang des Wellenleitungswegs vorgesehen ist, aufweist.

## Revendications

1. Dispositif SAW comprenant :
un substrat piézoélectrique (1a) ;
un ou plusieurs transducteurs interdigités (5a, 5b ; 5c) qui sont formés sur ledit substrat piézoélectrique (1a);
une pluralité de bornes d'électrode d'entrée/sortie (7a, 7b, 8a, 8b ; 9a, 9b) qui sont connectées électriquement audit transducteur interdigité (5a, 5b ; 5c), les bornes de ladite pluralité de bornes d'électrode d'entrée/sortie incluant au moins des premières (7a, 7b; 9a) et des secondes (8a, 8b ; 9b) bornes d'électrode d'entrée/sortie qui sont agencées sur les deux côtés dudit transducteur interdigité au niveau de côtés de la voie d'onde,
caractérisé par :
un substrat de base (2) comportant ledit élément SAW (1) sur carte ; et
un capuchon (3) qui est lié audit substrat de base (2) pour renfermer ledit élément SAW (1);
dans lequel la relation L2 < 3,5 x L3 qui est satisfaite suppose que L2 représente la distance de centre entre lesdites premières et secondes bornes d'électrode d'entrée/sortie et L3 représente la distance entre les extrémités externes de la zone occupée par ledit un ou lesdits plusieurs transducteurs interdigités (5a, 5b ; 5c) suivant ladite voie d'onde.

2. Dispositif SAW selon la revendication 1, dans lequel ledit un ou lesdits plusieurs transducteurs interdigités incluent des premier et second transducteurs interdigités (5a, 5b).

3. Dispositif SAW selon la revendication 2, dans lequel une paire de premières bornes d'électrode d'entrée/sortie (7a, 7b) et une paire de secondes bornes d'électrode d'entrée/sortie (8a, 8b) sont connectées électriquement respectivement auxdits premier et second transducteurs interdigités (5a, 5b).

4. Dispositif SAW selon l'une quelconque des revendications 1 à 3, dans lequel ledit élément SAW (1) est fixé sur ledit substrat de base (2) au moyen d'un matériau de liaison conducteur (4a, 4b) par l'intermédiaire d'une liaison à face dirigée vers le bas.

5. Dispositif SAW selon la revendication 4, dans lequel ledit matériau de liaison conducteur (4a, 4b) est un bossement de soudure.

6. Dispositif SAW selon la revendication 1, dans lequel ledit capuchon (3) est fixé audit substrat de base (2) au moyen d'un matériau de liaison conducteur (4c).

7. Dispositif SAW selon l'une quelconque des revendications 1 à 4, dans lequel ledit un ou lesdits plusieurs transducteurs interdigités (5a, 5b ; 5c) sont fixés audit substrat de base (2) au moyen d'un matériau de liaison conducteur.

8. Dispositif SAW selon l'une quelconque des revendications 1 à 6, comportant en outre une paire de réflecteurs (6a, 6b ; 6c, 6d) qui sont prévus sur les deux côtés dudit un ou desdits plusieurs transducteurs interdigités (5a, 5b ; 5c) suivant ladite voie d'onde.
